# EUROPÄISCHE PATENTSCHRIFT

(11) **EP 0 980 074 B1**
(45) Veröffentlichungstag und Bekanntmachung des Hinweises auf die Patenterteilung: **15.06.2005**
(21) Anmeldenummer: 99115517.7
(22) Anmeldetag: 05.08.1999
(51) Int. Cl.: G11C 7/12

(54) **Kombinierte Vorlade- und Homogenisierschaltung**
Combined precharge and equalisation circuit
Circuit de précharge et d'égalisation

(30) Priorität: 13.08.1998 DE 19836736
(43) Veröffentlichungstag der Anmeldung: 16.02.2000
(73) Patentinhaber: Infineon Technologies AG, 81669 München (DE)
(72) Erfinder: Schneider, Helmut, 80993 München (DE); Wagner, Michael, 82293 Mittelstetten (DE)
(74) Vertreter: Müller - Hoffmann & Partner

(56) Entgegenhaltungen:
- US-A- 4 570 083
- US-A- 5 604 365
- US-A- 5 652 726

## Beschreibung

Die Erfindung betrifft eine kombinierte Vorlade- und Homogenisierschaltung für eine Halbleiterspeicheranordnung aus einem Speicherzellenfeld mit einer Vielzahl von Bitleitungspaaren, umfassend einen ersten und einen zweiten Feldeffekt-Vorladetransistor und einen Homogenisiertransistor, der in Reihe zwischen den beiden Vorladetransistoren liegt, wobei die Gates der beiden Vorladetransistoren und des Homogenisiertransistors zu einem gemeinsamen Gate, Sources der Vorladetransistoren zu einer gemeinsamen Source, Drain des ersten Vorladetransistors und Drain des Homogenisiertransistors zu einer gemeinsamen Drain und Source des Homogenisiertransistors und Drain des zweiten Vorladetransistors zu einer gemeinsamen Source/Drain zusammengeschaltet sind.

Eine derartige kombinierte Vorlade- und Homogenisierschaltung dient unter anderem dazu, die Bitleitungen von DRAM-Speicheranordnungen im inaktiven Zustand auf ein vorgegebenes Potential vorzuladen und beide Bitleitungen eines Bitleitungspaares mit gemeinsamen Schreib-/Leseverstärker zu homogenisieren. Das vorgegebene Potential wird dabei durch die beiden Vorladetransistoren eingestellt, während die Homogenisierung der Bitleitungen durch einen Equalizer-Transistor erfolgt.

Bestehende kombinierte Vorlade- und Homogenisierschaltungen wie z. B. in US 5,604,365, haben einen relativ großen Abstand zwischen den beiden Bitleitungen, was auf den Platzbedarf für die Vorladetransistoren, den Homogenisiertransistor und gegebenenfalls einen Leckstrombegrenzer zurückzuführen ist. Die Verringerung dieses großen Abstandes stellt ein zentrales Problem bei der angestrebten Verkleinerung von Speicherzellen dar.

Es ist daher Aufgabe der vorliegenden Erfindung, eine kombinierte Vorlade- und Homogenisierschaltung zu schaffen, die sich durch einen kleinen Platzbedarf auszeichnet, so daß die Bitleitungen eines Bitleitungspaares eng nebeneinander geführt werden können.

Diese Aufgabe wird bei einer kombinierten Vorlade- und Homogenisierschaltung der eingangs genannten Art erfindungsgemäß dadurch gelöst, daß das gemeinsame Gate abgewinkelt und in bezug auf die Längsrichtung der Bitleitungen um etwa 45° gedreht gestaltet ist, daß das gemeinsame Drain und das gemeinsame Source/Drain über das gemeinsame Gate hinaus mit vorstehenden Bereichen vorgezogen sind und daß die Bitleitungskontakte in diesen vorstehenden Bereichen untergebracht sind.

Gegebenenfalls kann noch ein Leckstrombegrenzer in Reihe zu den Vorladetransistoren und dem Homogenisiertransistor liegen. Das gemeinsame Gate kann in bezug auf die Längsrichtung der Bitleitungen auch um von 45° abweichenden Winkeln gedreht sein. So sind beispielsweise Winkel zwischen 30° und 60° ohne weiteres denkbar.

Der Platzbedarf für die erfindungsgemäße Vorlade- und Homogenisierschaltung ist geringer als der Platzbedarf bestehender Vorlade- und Homogenisierschaltungen. Durch "Abknicken" des gemeinsamen Gates, die Drehung um etwa 45° und das Unterbringen der Bitleitungskontakte in den vorgezogenen Bereichen sind eine erhebliche Verringerung des Abstandes der Bitleitungen und eine flexible Dimensionierung des Homogenisiertransistors möglich. Dadurch ist es möglich, Speicherzellen kleiner zu gestalten und auch die Bitleitungen länger zu machen.

Nachfolgend wird die Erfindung anhand der Zeichnungen näher erläutert. Es zeigen:
- Fig. 1: ein Schaltbild eines ersten Beispiels einer Vorlade- und Homogenisierschaltung,
- Fig. 2: ein Schaltbild eines zweiten Beispiels einer Vorlade- und Homogenisierschaltung,
- Fig. 3: eine Draufsicht auf die Gatestruktur für eine bestehende Schaltung von Fig. 1 gemäß der Erfindung und
- Fig. 4: eine Draufsicht auf die Gatestruktur für die Schaltung von Fig. 1 gemäß der Erfindung.

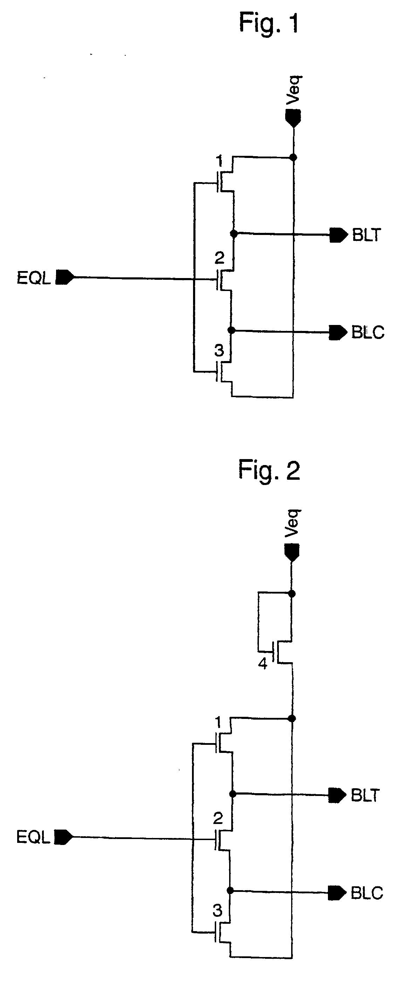

Fig. 1 zeigt eine kombinierte Vorlade- und Homogenisierschaltung mit Vorladetransistoren 1 und 3, zwischen denen in Reihe ein Homogenisiertransistor 2 vorgesehen ist. Der Transistor 2 ist an seinem Gate mit einem Signal EQL beaufschlagt, während die Enden der durch die Transistoren 1 bis 3 gebildeten Reihenschaltung auf einem Potential Veq liegen. Die Gates der Transistoren 1 und 3 sind zusammengeschaltet, und die gemeinsamen Knoten zwischen den Transistoren 1 und 2 bzw. 2 und 3 sind mit Bitleitungen BLT bzw. BLC eines Bitleitungspaars verbunden. Die Aktivierung dieser Bitleitungen erfolgt in üblicher Weise durch Anlegen des Signales EQL und eines Signales ISO an in den Bitleitungen vorgesehene (nicht gezeigte) Transistoren.

Bei der Schaltung von Fig. 2 ist zusätzlich noch ein Leckstrom-Begrenzer 4 in der Form eines Transistors vorgesehen, der als Widerstand wirkt und in Reihe zu den Transistoren 1 bis 3 liegt.

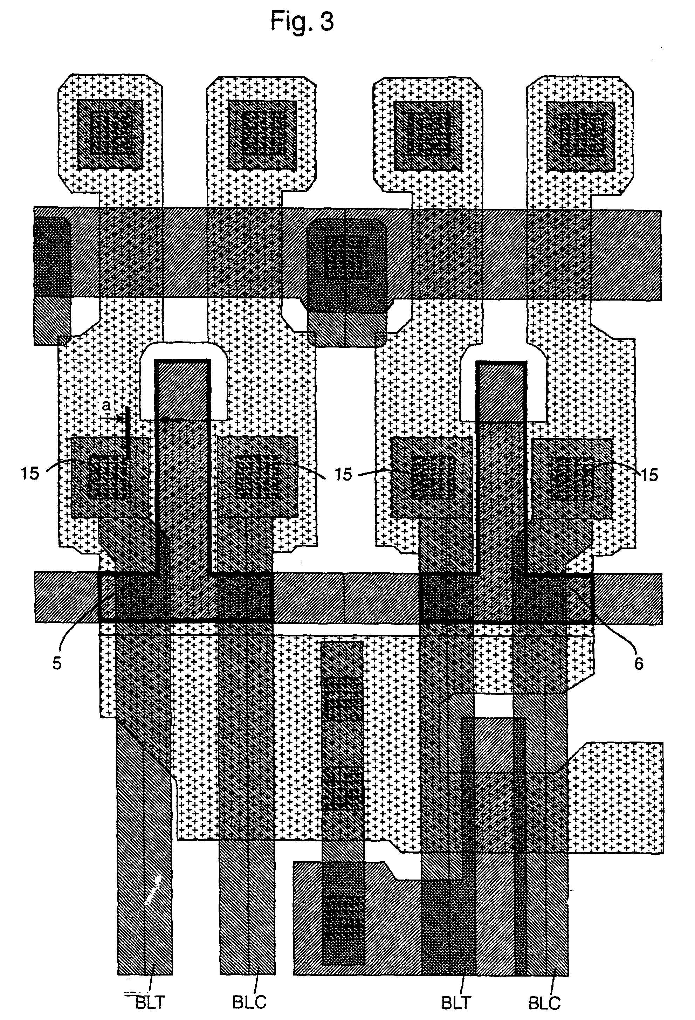

Wie aus Fig. 3 zu ersehen ist, sind bei einer bestehenden Schaltung Gates 5, 6 der Transistoren 1 bis 3 im wesentlichen abgewinkelt "T"-förmig ausgebildet, wobei links von dem Querbalken des "T" Sources der beiden Transistoren 1 und 3 und auf einander gegenüberliegenden Seiten des Längsbalkens des "T" Drain des Vorladetransistors 1 und Drain des Homogenisiertransistors 2 bzw. Source des Homogenisiertransistors 2 und Drain des Vorladetransistors 3 angeordnet sind. Bitleitungskontakte 15 zu den Bitleitungen BLT, BLC sind bei dieser bestehenden Schaltung beidseitig von den Gates 5, 6 angeordnet.

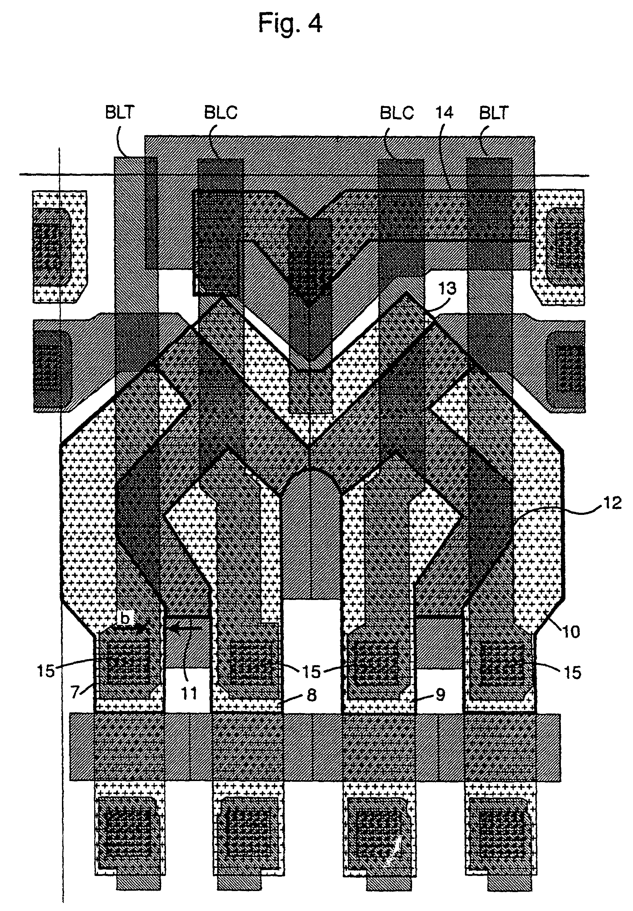

Fig. 4 zeigt ein Ausführungsbeispiel der Erfindung mit Sources 13 der beiden Vorladetransistoren 1, 3, Drain 7 (oder 10) des ersten Vorladetransistors 1 bzw. des Homogenisiertransistors 2 und Source 8 (oder 9) des Homogenisiertransistors 2 bzw. Drain 8 des zweiten Vorladetransistors 3. Das heißt, die Drains des ersten Vorladetransistors und des Homogenisiertransistors 2 sind zu einem gemeinsamen Drain 7 (oder 10) und Source des Homogenisiertransistors 2 und Drain des zweiten Vorladetransistors 3 sind zu einem gemeinsamen Source/Drain 8 (oder 9) zusammengeschaltet. Außerdem zeigt Fig. 4 noch Gate 14 des Leckstrom-Begrenzers 4.

Bei der Schaltung gemäß dem Ausführungsbeispiel von Fig. 4 sind die Gates 11 (oder 12) nicht nur abgewinkelt, sondern zusätzlich noch um etwa 45° in bezug auf die Längsrichtung der Bitleitungen BLT und BLC gedreht. Durch die abgewinkelte und gedrehte Ausführung der Gates läßt sich der Platzbedarf für die Vorlade- und Homogenisierschaltung erheblich verringern, da die Bitleitungskontakte 15 "herausgezogen" werden können, so daß die Bitleitungen der jeweiligen Bitleitungspaare BLT, BLC eng nebeneinander geführt werden können. Die Bitleitungskontakte 15 sind also in vorstehenden Bereichen der gemeinsamen Source/Drain 8, 9 bzw. des gemeinsamen Drains 7, 10 untergebracht, die über das gemeinsame Gate 11 bzw. 12 hinausragen. Insbesondere ist es möglich, den Abstand b zwischen Bitleitungskontakt 15 und der Kante des polykristallinen Materials kleiner als beim Stand der Technik (vgl. "a" in Fig. 3) zu machen.

## Patentansprüche

1. Kombinierte Vorlade- und Homogenisierschaltung für eine Halbleiterspeicheranordnung aus einem Speicherzellenfeld mit einer Vielzahl von Bitleitungspaaren, umfassend einen ersten und einen zweiten Feldeffekt-Vorladetransistor (1, 3) und einen Homogenisiertransistor (2), der in Reihe zwischen den beiden Vorladetransistoren (1, 3) liegt, wobei die Gates der beiden Vorladetransistoren (1, 3) und des Homogenisiertransistors (2) zu einem gemeinsamen Gate (11, 12), Sources der Vorladetransistoren (1, 3) zu einer gemeinsamen Source (13), Drain des ersten Vorladetransistors (1) und Drain des Homogenisiertransistors (2) zu einer gemeinsamen Drain (7, 10) und Source des Homogenisiertransistors (2) und Drain des zweiten Vorladetransistors (3) zu einer gemeinsamen Source/Drain (8, 9) zusammengeschaltet sind,
**dadurch gekennzeichnet,**
**daß** das gemeinsame Gate (11, 12) abgewinkelt und in bezug auf die Längsrichtung der Bitleitungen (BLT, BLC) um etwa 45° gedreht gestaltet ist, daß das gemeinsame Drain (7, 10) und das gemeinsame Source/Drain (8, 9) über das gemeinsame Gate (11, 12) hinaus mit vorstehenden Bereichen vorgezogen sind, und daß die Bitleitungskontakte (15) in diesen vorstehenden Bereichen untergebracht sind.

2. Kombinierte Vorlade- und Homogenisierschaltung nach Anspruch 1,
**gekennzeichnet durch**
einen Leckstrombegrenzer (4), der in Reihe zu den Vorladetransistoren (1, 3) und dem Homogenisiertransistor (2) liegt.

## Claims

1. Combined precharging and homogenizing circuit for a semiconductor memory arrangement made up of a memory cell array having a multiplicity of bit line pairs, comprising a first and a second field-effect precharging transistor (1, 3) and a homogenizing transistor (2) connected in series between the two precharging transistors (1, 3), the gates of the two precharging transistors (1, 3) and of the homogenizing transistor (2) being connected together to form a common gate (11, 12), the sources of the precharging transistors (1, 3) being connected together to form a common source (13), the drain of the first precharging transistor (1) and the drain of the homogenizing transistor (2) being connected together to form a common drain (7, 10) and the source of the homogenizing transistor (2) and the drain of the second precharging transistor (3) being connected together to form a common source/drain (8, 9), **characterized in that** the common gate (11, 12) is angled and is designed rotated through about 45° in relation to the longitudinal direction of the bit lines (BLT, BLC), **in that** the common drain (7, 10) and the common source/drain (8, 9) are drawn forwards beyond the common gate (11, 12) by means of protruding regions, and **in that** the bit line contacts (15) are accommodated in these protruding regions.

2. Combined precharging and homogenizing circuit according to Claim 1, **characterized by** a leakage current limiter (4) connected in series with the precharging transistors (1, 3) and the homogenizing transistor (2).

## Revendications

1. Circuit combiné de précharge et d'égalisation pour un dispositif de mémoire à semi-conducteur constitué d'un champ de cellules de mémoire ayant une pluralité de paires de lignes de bits, comprenant un premier et un deuxième transistor (1, 3) de précharge à effet de champ et un transistor (2) d'égalisation qui est monté en série entre les deux transistors (1, 3) de précharge, les grilles des deux transistors (1, 3) de précharge et du transistor (2) d'égalisation étant réunies en une grille (11, 12) commune, les sources des transistors (1, 3) de précharge étant réunies en une source (13) commune, le drain du premier transistor (1) de précharge et le drain du transistor (2) d'égalisation étant réunis en un drain (7, 10) commun et la source du transistor (2) d'égalisation et le drain du deuxième transistor (3) de précharge étant réunis en une source/drain (8, 9) commun,
**caractérisé en ce que** la grille (11, 12) commune est coudée et est tournée d'environ 45° par rapport à la direction longitudinale des lignes (BLT, BLC) de bits, **en ce que** le drain (7, 10) commun et la source/drain (8, 9) commun vont au-delà de la grille (11, 12) commune par des parties en saillie, et **en ce que** les contacts (15) de lignes de bits sont logés dans ces parties en saillie.

2. Circuit combiné de précharge et d'égalisation suivant la revendication 1,
**caractérisé par** un limiteur (4) de courant de fuite qui est monté en série avec les transistors (1, 3) de précharge et le transistor (2) d'égalisation.
